# EUROPÄISCHE PATENTSCHRIFT

(11) **EP 1 788 574 B1**
(45) Veröffentlichungstag und Bekanntmachung des Hinweises auf die Patenterteilung: **04.04.2012**
(21) Anmeldenummer: 05025054.7
(22) Anmeldetag: 16.11.2005
(51) Int. Cl.: G11C 5/14

(54) **Elektrisches Gerät dessen Speicherdaten auch bei Defekt auslesbar sind**
Electric device with stored data which are readable even in case of failure
Dispositif electrique avec données stockees lisibles même en cas de défaillance

(43) Veröffentlichungstag der Anmeldung: 23.05.2007
(73) Patentinhaber: SIEMENS AKTIENGESELLSCHAFT, 80333 München (DE)
(72) Erfinder: Donderer, Markus, 92224 Amberg (DE)

(56) Entgegenhaltungen:
- EP-A- 1 049 099
- US-A- 5 517 447
- US-A- 2003 112 376
- US-A1- 2004 052 109

## Beschreibung

Die Erfindung betrifft ein elektrisches Gerät mit einem Controller, einem I2C EEPROM (Electrically Erasable Programmable Read Only Memory), einer Stromversorgungseinheit, die mit dem Controller und dem I2C EEPROM elektrisch verbunden ist, einer Takt- und einer Datenleitung, die beide den Controller mit dem I2C EEPROM verbinden, einem ersten an der Datenleitung angeschlossenen Widerstand, einem zweiten an der Taktleitung angeschlossenen Widerstand, wobei der jeweils andere Anschluss der beiden Widerstände an der elektrischen Verbindung zwischen der Stromversorgungseinheit und dem I2C EEPROM liegt.

Derartige elektrische Geräte, wie zum Beispiel in der EP 1 049 099 offenbart, sind in hoher Schutzart bekannt, wobei in dem Speichermedium, d.h. dem I2C EEPROM üblicherweise der Stationsname und ggf. auch noch andere Daten wie Typschild und Wartungsinformationen hinterlegt sind. Um bei einem Defekt den Stationsnamen auf ein neues Gerät übertragen zu können, wird bisher ein wechselbares Speichermedium verwendet, das dem defekten Gerät entnommen und in das neue Gerät gesteckt wird. In der Regel können die im defekten Gerät gespeicherten Daten nicht mehr ausgelesen werden.

Ein wechselbares Speichermedium erhöht die Herstellkosten, indem zusätzliche Steckverbinder, ein zusätzlicher Modulschacht, ggf. eine zusätzliche Leiterplatte und ein Speichermedium mit einem Gehäuse erforderlich sind. Der Kunde muss für jedes Gerät ein solches Speichermedium kaufen.

Der Erfindung liegt die Aufgabe zugrunde, ein elektrisches Gerät der oben genannten Art zu verbessern, das mit möglichst wenig zusätzlichen Anschlüssen das I2C EEPROM einem externen Schreib-/Lesegerät zum Auslesen von im I2C EEPROM gespeicherten Daten zugänglich zu machen, ohne dass der Rest der Schaltung funktionieren muss.

Die Aufgabe wird dadurch gelöst, dass zwei von außen zugängliche Anschlüsse vorgesehen sind, wobei der erste Anschluss mit der Leitung und der zweite Anschluss mit der Datenleitung verbunden ist, dass in der elektrischen Verbindung zwischen der Stromversorgungseinheit und den beiden Widerständen eine Entkoppeldiode liegt, und dass ein Kondensator mit dem Stromversorgungsanschluss des I2C EEPROM elektrisch verbunden ist, so dass bei einem Defekt der Stromversorgungseinheit über die Anschlüsse mit einem Schreib-/Lesegerät Daten aus dem 12C EEPROM auslesbar sind, da über die Anschlüsse mit dem Schreib-/Lesegerät Spannung an die Taktleitung und an die Datenleitung anlegbar ist, um den Controller und den 12C EEPROM mit Strom zu versorgen.

Der Vorteil dieser Lösung besteht auch darin, dass die Stromversorgungseinheit nicht in Betrieb sein muss, da bei einem Defekt die Funktion der Stromversorgungseinheit oder des Controllers beeinträchtigt sein kann. Bei dieser Lösung ist weiterhin besonders vorteilhaft, dass das Lesegerät keine Spannungsversorgung für das I2C EEPROM zusätzlich einspeisen muss, da die Versorgung des I2C EEPROMs über seine I2C-Schnittstelle erfolgt. Ein Ausführungsbeispiel der Erfindung wird anhand der folgenden Zeichnung erklärt.

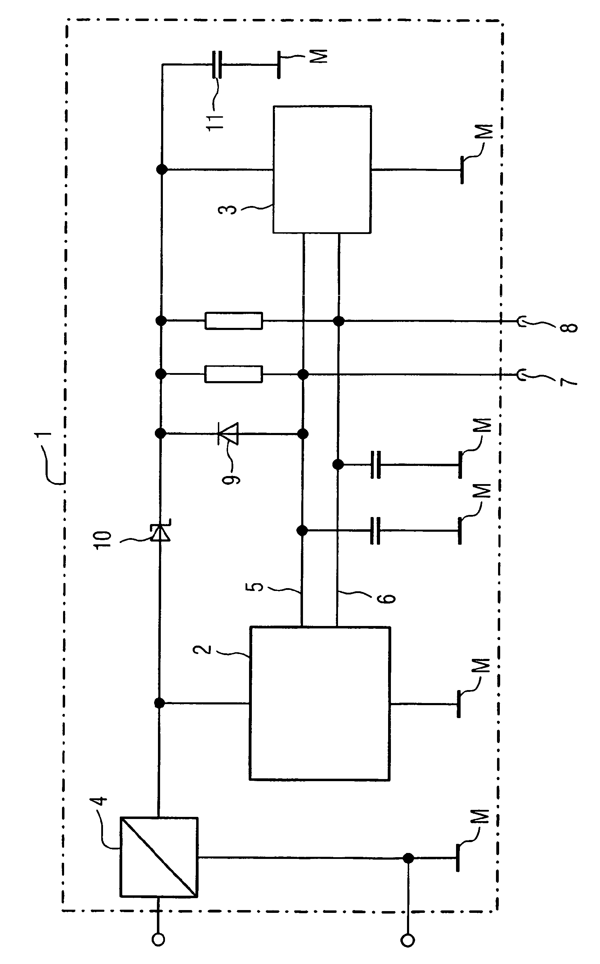

Die Zeichnung zeigt ein elektrisches Gerät 1 mit einem Controller 2, einem I2C EEPROM (Electrically Erasable Programmable Read Only Memory) 3 und einer Stromversorgungseinheit 4, hier z.B. ein Gleichstromwandler. Die Stromversorgungseinheit 4 ist mit dem Controller 2 und dem I2C EEPROM 3 elektrisch verbunden. Der Controller 2 und das I2C EEPROM 3 sind durch eine Taktleitung 5 und eine Datenleitung 6 elektrisch miteinander verbunden. An der Datenleitung 6 ist ein erster Widerstand R1 und an der Taktleitung 5 ist ein zweiter Widerstand R2 angeschlossen. Der jeweils andere Anschluss der beiden Widerstände R1, R2 liegt an der elektrischen Verbindung zwischen der Stromversorgungseinheit 4 und dem I2C EEPROM 3. Am elektrischen Gerät 1 sind zwei von außen zugängliche Anschlüsse vorgesehen, wobei der erste Anschluss 7 mit der Taktleitung 5 und der zweite Anschluss 8 mit der Datenleitung 6 elektrisch verbunden ist. In der elektrischen Verbindung zwischen der Stromversorgungseinheit 4 und den beiden Widerständen R1 und R2 liegt eine Entkoppeldiode 10. Ein Kondensator 11 ist mit dem Stromversorgungsanschluss des I2C EEPROMs 3 elektrisch verbunden. Mit dem Bezugszeichen M sind die Massepins der Schaltung bezeichnet.

Das Lesegerät bzw. Schreib-/Lesegerät wird zum Auslesen der im I2C EEPROM 3 gespeicherten Daten an den bereits bestehenden Massepin M und die beiden zusätzlichen Anschlüsse 7 und 8 an das Gerät angeschlossen. Das Schreib-/Lesegerät hat seine eigene Versorgung und liegt Spannung an die Taktleitung 5 und die Datenleitung 6. Solange keine Übertragung läuft, wird der Kondensator 11 über die Diode 10 geladen, da bei einem I2C-Bus der Highpegel den Ruhezustand darstellt. Durch die zur Entkopplung dienende Diode 9 wird verhindert, dass der Rest der Schaltung auch mit versorgt wird.

Sobald Daten über die Taktleitung 5 und Datenleitung 6 übertragen werden, werden die auf Massepotential gezogen und das I2C EEPROM 3 und die Widerstände R1 und R2 aus dem Kondensator 11 versorgt.

Da das Schreib-/Lesegerät für die Kommunikation den Master darstellt, kann er die Übertragungsfrequenz und ggf. Übertragungspausen zum Aufladen des Kondensators 11 selbst vorgeben. Die Dimensionierung des Kondensators 11 muss dementsprechend vorgenommen werden.

Die Lösung besteht im Wesentlichen darin, dass die I2C-Schnittstelle des I2C EEPROMs 3 nach außen geführt wird. Mit einem daran angeschlossenen Schreib-/Lesegerät können die Adressierungs-/Identifikationsdaten von einem defekten Gerät ausgelesen werden.

Insgesamt ergeben sich bei der oben beschriebenen Lösung folgende Vorteile:
- Selbst bei einem Gerätedefekt können die gespeicherten Daten ausgelesen werden. Gerade die hinterlegten Wartungsinformationen gingen sonst verloren.
- Bei einem Gerät in hoher Schutzart muss keine zusätzliche, verschließbare Öffnung für ein tauschbares Wechselmedium geschaffen werden.
- Die beiden zusätzlich notwendigen Anschlüsse können ggf. auf vorhandene Stecker gelegt werden.

### Beispiele:

- Verwendung eines 5poligen M12-Steckverbinders statt eines 3poligen.
- Ungenutzte Pins bei z.B. 7/8 Stecker können genutzt werden.
- Deutliche Kostenersparnis gegenüber einer Lösung mit wechselbarem Speichermedium.

## Patentansprüche

1. Elektrisches Gerät (1) mit einem Controller (2), einem I2C EEPROM (3), einer Stromversorgungseinheit (4), die mit dem Controller (2) und dem I2C EEPROM (3) elektrisch verbunden ist, einem Kondensator (11) der mit einem Stromversorgungsanschluss des I2C EEPROMs (3) elektrisch verbunden ist, einer Taktleitung (5) und einer Datenleitung (6), die beide den Controller (2) mit dem I2C EEPROM (3) verbinden, einem ersten an der Datenleitung (6) angeschlossenen Widerstand (R1), einem zweiten an der Taktleitung (5) angeschlossenen Widerstand (R2), wobei der jeweils andere Anschluss der beiden Widerstände (R1, R2) an die elektrische Verbindung zwischen der Stromversorgungseinheit (4) und dem I2C EEPROM (3) liegt, **dadurch gekennzeichnet, dass** zwei von außen zugängliche Anschlüsse vorgesehen sind, wobei der erste Anschluss (7) mit der Taktleitung (5) und der zweite Anschluss (8) mit der Datenleitung (6) verbunden ist, dass in der elektrischen Verbindung zwischen der Stromversorgungseinheit (4) und den beiden Widerständen (R1, R2) eine Entkoppeldiode (10) liegt, so dass bei einem Defekt der Stromversorgungseinheit (4) über die Anschlüsse (7,8) mit einem Schreib-/Lesegerät Daten aus dem 12C EEPROM (3) auslesbar sind, da über die Anschlüsse (7,8) mit dem Schreib-/Lesegerät Spannung an die Taktleitung (5) und an die Datenleitung (6) anlegbar ist, um den Controller (2) und den 12C EEPROM (3) mit Strom zu versorgen.

## Claims

1. Electrical device (1) comprising a controller (2), an I2C EEPROM (3), a power supply unit (4) which is electrically connected to the controller (2) and the I2C EEPROM (3), a capacitor (11) which is electrically connected to a power supply terminal of the I2C EEPROM (3), a clock line (5) and a data line (6), both of which connect the controller (2) to the I2C EEPROM (3), a first resistor (R1) connected to the data line (6), a second resistor (R2) connected to the clock line (5), with the other terminal of the two resistors (R1, R2) in each case being disposed in the electrical connection between the power supply unit (4) and the I2C EEPROM (3), **characterised in that** two externally accessible terminals are provided, with the first terminal (7) being connected to the clock line (5) and the second terminal (8) being connected to the data line (6), **in that** a decoupling diode (10) is disposed in the electrical connection between the power supply unit (4) and the two resistors (R1, R2), such that in the event of a fault in the power supply unit (4) data can be read out from the I2C EEPROM (3) via the terminals (7,8) by means of a read-write device, since voltage can be applied to the clock line (5) and to the data line (6) via the terminals (7,8) by means of the read-write device in order to supply the controller (2) and the I2C EEPROM (3) with electric current.

## Revendications

1. Appareil ( 1 ) électrique comprenant une unité ( 2 ) de commande, une I2C EEPROM ( 3 ), une unité ( 4 ) d'alimentation en courant qui est reliée électriquement à l'unité ( 2 ) de commande et à l'I2C EEPROM ( 3 ), un condensateur ( 11 ) qui est relié électriquement à une borne d'alimentation en courant de l'I2C EEPROM ( 3 ), un condensateur ( 11 ) qui est relié électriquement à une borne d'alimentation en courant de l'I2C EEPROM ( 3 ), une ligne ( 5 ) d'horloge et une ligne ( 6 ) de données qui relient toutes les deux l'unité ( 2 ) de commande à l'I2C EEPROM ( 3 ), une première résistance ( R1 ) raccordée à la ligne ( 6 ) de données, une deuxième résistance ( R2 ) raccordée à la ligne ( 5 ) d'horloge, l'autre borne respective des deux résistances ( R1, R2 ) se trouvant à la liaison électrique entre l'unité ( 4 ) d'alimentation en courant et l'I2C EEPROM ( 3 ), **caractérisé en ce qu'**il est prévu deux bornes extérieures accessibles, la première borne ( 7 ) étant reliée à la ligne ( 5 ) d'horloge et la deuxième borne ( 8 ) à la ligne ( 6 ) de données, **en ce que** dans la liaison électrique entre l'unité ( 4 ) d'alimentation en courant et les deux résistances ( R1, R2 ) se trouve une diode ( 10 ) de découplage de sorte que, si l'unité ( 4 ) d'alimentation en courant est défectueuse, des données peuvent être lues dans la I2C EEPROM ( 3 ) par l'intermédiaire des bornes ( 7, 8 ) par un appareil d'écriture/lecture, puisque par les bornes ( 7, 8 ) il peut être appliquée par l'appareil d'écriture/lecture une tension à la ligne ( 5 ) d'horloge et à la ligne ( 6 ) de données pour alimenter en courant l'unité ( 2 ) de commande et la I2C EEPROM ( 3 ).
